# EUROPÄISCHE PATENTANMELDUNG

(11) **EP 2 128 900 A2**
(43) Veröffentlichungstag der Anmeldung: **02.12.2009**
(21) Anmeldenummer: 09007197.8
(22) Anmeldetag: 29.05.2009
(51) Int. Cl.: H01L 25/075, H01L 33/00

(54) **Leuchtmittel**

(30) Priorität: 30.05.2008 AT 8762008
(71) Anmelder: Kuster, Martin, 6381 Walchwill (CH)
(72) Erfinder: Kuster, Martin, 6381 Walchwill (CH)
(74) Vertreter: Ofner, Clemens

(57) **Zusammenfassung**

Die Erfindung betrifft ein Leuchtmittel (1), welches eine Strahlungsquelle (4) zur Abgabe von elektromagnetischer Strahlung im optischen Bereich, eine Trägerlage (2) und eine Elektrodenanordnung (3) mit einer ersten (7) und zumindest zweiten (8) Elektrode umfasst. Die Strahlungsquelle (4) ist auf der Trägerlage (2) angeordnet und mittels Verbindungsleitungen mit der Elektrodenanordnung (3) elektrisch leitend verbunden, wobei ferner die Strahlungsquelle (4) durch ein erstes (5) und zumindest zweites (6) Halbleiterbauteil gebildet ist. Die erste Elektrode (7) ist mit dem ersten Halbleiterbauteil (5) über einen ersten Kontaktpunkt (9) elektrisch leitend verbunden und die zweite Elektrode (8) ist mit dem zweiten Halbleiterbauteil (6) über einen zweiten Kontaktpunkt (10) elektrisch leitend verbunden. Der Abstand des ersten Kontaktpunkts (9) von einem Mittelpunkt (11) bzw. einer Symmetrielinie (12) der Trägerlage (2) ist unterschiedlich vom Abstand des zweiten Kontaktpunkts (10) zum Mittelpunkt (11) bzw. zur Symmetrielinie (12) der Trägerlage.

## Beschreibung

Die Erfindung betrifft ein Leuchtmittel, umfassend eine Strahlungsquelle zur Abgabe von elektromagnetischer Strahlung im optischen Bereich, eine Trägerlage und eine Elektrodenanordnung mit einer ersten und zumindest zweiten Elektrode, wobei die Strahlungsquelle auf der Trägerlage angeordnet ist und mittels Verbindungsleitungen mit der Elektrodenanordnung elektrisch leitend verbunden ist, wobei die Strahlungsquelle durch ein erstes und zumindest zweites Halbleiterbauteil gebildet ist, wobei die erste Elektrode mit dem ersten Halbleiterbauteil über einen ersten Kontaktpunkt elektrisch leitend verbunden ist und die zweite Elektrode mit dem zweiten Halbleiterbauteil über einen zweiten Kontaktpunkt elektrisch leitend verbunden ist.

Leuchtmittel die auf nicht thermischer Strahlungserzeugung basieren, zeichnen sich zumeist durch einen besonders hohen Wirkungsgrad, eine lange Lebensdauer, sowie einen besonders kompakten Aufbau aus und sind weiters besonders robust in Hinsicht auf die mechanische Belastbarkeit. Insbesondere aufgrund des kompakten Aufbaus sind derartige Leuchtmittel zumeist in anderen Modulen angeordnet, wobei eine Anordnung bevorzugt wird, bei der das Leuchtmittel ein integrierter Baustein eines größeren Moduls ist. Aufgrund der hohen Integration ist jedoch eine Austauschbarkeit im Schadensfall zumeist nicht oder nur sehr eingeschränkt möglich. Beispielsweise werden derartige Leuchtmittel des Öfteren in einem Modul angeordnet und mittels eines Füllmaterials in diesem fixiert und so gegenüber Umwelteinflüssen wie bspw. Feuchtigkeit oder aggressiven Gasen dicht abgeschlossen. Bei Ausfall eines Leuchtmittels eines Leuchtmittels kann es somit zu einer Funktionseinschränkung kommen, wodurch in bekannter Weise als Ersatz zumeist zusätzliche, für die bestimmungsgemäße Funktion nicht erforderliche Leuchtmittel angeordnet werden. Diese Leuchtmittel sind beim bestimmungsgemäßen Betrieb nicht aktiv und werden erst im Schadensfall eines Leuchtmittels in Betrieb genommen und erhöhen somit einerseits die Kosten des Leuchtmittels und erfordern außerdem zusätzlichen Platz für deren Anordnung.

Bekannte Leuchtmittel aus Halbleiterbausteinen haben insbesondere den Nachteil, dass aufgrund der erforderlichen elektrischen Kontaktierung, ein Teilabschnitt der Licht abgebenden Fläche durch den Kontaktierungspunkt abgeschattet wird. Derartige Leuchtmittel weisen daher im Strahlungsbild einen Bereich mit einer deutlich reduzierten Strahlungsintensität auf, was jedoch für die Erreichung einer möglichst gleichmäßigen Ausleuchtung von Nachteil ist.

Die Aufgabe der Erfindung liegt nun darin, ein möglichst ausfallsicheres Leuchtmittel zu schaffen, dass eine möglichst gleichmäßige Intensitätsverteilung des abgegebenen Strahlungsbilds aufweist.

Die Aufgabe der Erfindung wird dadurch gelöst, dass der Abstand des ersten Kontaktpunkts von einem Mittelpunkt bzw. einer Symmetrielinie der Trägerlage unterschiedlich ist vom Abstand des zweiten Kontaktpunkts zum Mittelpunkt bzw. zur Symmetrielinie der Trägerlage. Die Trägerlage, insbesondere der Abschnitt auf dem das erste und zweite Halbleiterbauteil angeordnet ist, weist zumeist immer eine Art von Symmetrie auf. Beispielsweise kann die Trägerlage weitestgehend kreisrund, oder rechteckig, insbesondere quadratisch ausgebildet sein. Die Trägerlage kann noch weitere Komponenten umfassen bzw. können um die Trägerlage zusätzliche Komponenten angeordnet sein. Die Symmetrieeigenschaften beziehen sich hier ausschließlich auf den Abschnitt der Trägerlage, auf dem die Halbleiterbauteile angeordnet sind.

In einer makroskopischen Betrachtung kann die Trägerlage und die darauf angeordneten Halbleiterbauteile näherungsweise als Licht abgebende Fläche betrachtet werden, wobei das abgegebene Licht bevorzugt in eine Hauptstrahlrichtung abgegeben wird. Die weiteren Betrachtungen hinsichtlich der Symmetrieangaben beziehen sich nun auf diese bauartbestimmte Hauptabstrahlungsrichtung.

Bei bekannten Leuchtmittel werden Halbleiterbauteile zumeist derart auf der Trägerlage angeordnet, dass dies für den Fertigungsprozess einfach durchführbar ist bzw. dass sie im optischen Zentrum angeordnet sind, wobei das optische Zentrum zumeist mit dem Mittelpunkt bzw. der Symmetrielinie zusammenfällt. Insbesondere sind jedoch die Kontaktierungspunkte bzgl. einer Symmetrielinie bzw. bzgl. des Mittelpunkts zumeist im selben Abstand angeordnet. Durch diese Anordnung kommt es jedoch im Bereich des Licht abgebenden Abschnitts der Halbleiterbauteile zu einer Abschattung, die im abgegebenen Lichtstrahl zu einem Abschnitt mit deutlich reduzierter Strahlungsintensität führt.

Durch die erfindungsgemäße Ausbildung ist in ganz besonders vorteilhafter Weise sichergestellt, dass sich die vom ersten und zweiten Halbleiterbauteil abgegebenen Lichtstrahlen derart überlagern, dass die bauartbedingte Intensitätsschwankung im Strahlengang eliminiert bzw. reduziert wird. Die erfindungsgemäße Ausbildung hat den weiteren Vorteil, dass durch gezielte Ansteuerung des ersten und zweiten Halbleiterbauteils ein redundantes Leuchtmittel ausgebildet wird, wobei insbesondere von Vorteil ist, dass jedes einzelne Halbleiterbauteil mit einer geringeren als der Maximalleistung angesteuert werden kann, und trotzdem eine sehr hohe Strahlungsintensität erreicht wird. Durch diese vorteilhafte Ausbildung wird die Belastung der einzelnen Halbleiterbauteile deutlich reduziert, insbesondere reduziert sich die unvermeidliche Wärmeentwicklung, wodurch eine Erhöhung der Betriebssicherheit und insbesondere eine Verlängerung der Einsatzdauer erreicht werden.

Als elektrische Verbindungsleiter zwischen den Elektroden und den Halbleiterbauteilen werden bevorzugt flexible Leiter verwendet, die eine elektrische Kontaktierung zuverlässig sicherstellen und thermisch bedingte Dehnungseffekte ohne Beschädigung ausgleichen können.

Von Vorteil ist eine Weiterbildung, bei der das erste und zweite Halbleiterbauteil durch eine Leuchtdiode gebildet ist. Leuchtdioden gehören zur Gruppe der direkten Halbleiter, wobei es, in vereinfachter Darstellung, durch elektrische Anregung des Halbleitermaterials in der Rekombinationsschicht zur Abgabe elektromagnetischer Strahlung im optischen Bereich kommt. Leuchtdioden haben daher den besonderen Vorteil, das Licht aufgrund Wechselwirkungen in einem Halbleitermaterial erzeugt wird, was im Vergleich zur thermischen Lichterzeugung einen deutlich besseren Wirkungsgrad aufweist. Daher sind Leuchtdioden besonders robust und langlebig, was insbesondere für Leuchtmodule, bestehend aus mehreren erfindungsgemäßen Leuchtmitteln, von ganz entscheidendem Vorteil ist. Leuchtdioden haben den weiteren Vorteil, dass sich der Spektralbereich des abgegebenen Lichts, durch die Wahl des Materials der Rekombinationsschicht in weiten Bereichen gezielt festlegen lässt. Der abgegebene Spektralbereich weist zudem dann zumeist nur eine sehr geringe spektrale Breite auf.

Durch die Wahl der Materialien des Halbleiterbauteils erhält man vorteilhafte Weiterbildungen, bei denen das erste und/oder zweite Halbleiterbauteil eine elektromagnetische Strahlung im optisch sichtbaren Bereich bzw. im optisch nicht sichtbaren Bereich abgibt. Durch entsprechende Wahl der Materialkombinationen kann das Halbleiterbauteil nun in vorteilhafter Weise dazu ausgebildet werden, direkt sichtbares Licht abzugeben. Auch ist es mit entsprechender Materialkombination bei Halbleiterbauteilen möglich, elektromagnetische Strahlung im optisch nicht sichtbaren Bereich abzugeben. Durch diese vorteilhaften Weiterbildungen lässt sich ein Leuchtmittel ausbilden, dass in einem sehr großen Bereich des optischen Spektralbereichs zur Abgabe von Licht ausgebildet ist.

Im Hinblick auf die elektrische Kontaktierung der Halbleiterbauteile ist eine Weiterbildung von Vorteil, bei der die Trägerlage elektrisch leitend ausgebildet ist, da diese somit eine Elektrode, insbesondere eine dritte Elektrode der Elektrodenanordnung ausbildet. Durch diese Weiterbildung wird in vorteilhafter Weise die Anzahl der elektrischen Zuleitungselektroden reduziert und insbesondere die Fertigung des erfindungsgemäßen Leuchtmittels vereinfacht. Eine elektrisch leitende Trägerlage hat den weiteren Vorteil, dass elektrisch leitende Materialien üblicherweise auch eine gute thermische Leitfähigkeit aufweisen und somit die entstehende Abwärme gut abgeleitet werden kann.

Zur individuellen Ansteuerung der Halbleiterbauteil kann ggf. noch ein zusätzlicher Kontrollerbaustein auf der Trägerlage angeordnet sein. Dieser Baustein kann das erste und zweite Halbleiterbauteil gezielt unterschiedlich ansteuern, um so bspw. eine unterschiedliche Leuchtcharakteristik zu erreichen. Beispielsweise können die beiden Halbleiterbauteile elektromagnetische Strahlung in unterschiedlichen Spektralbereichen abgeben, wodurch mittels des Kontrollerbausteins die Mischfarbe der abgegebenen elektromagnetischen Strahlung einstellbar ist. Da das Halbleiterbauteil und der Kontrollerbaustein ggf. auf unterschiedlichem elektrischem Potential betrieben werden ist eine Weiterbildung von besonderem Vorteil, nach der die Trägerlage elektrisch nicht leitend ausgebildet ist, da es somit zu keiner gegenseitigen elektrischen Beeinflussung zwischen den Halbleiterbauteilen bzw. zwischen den Halbleiterbauteilen und dem Kontrollerbaustein kommen kann.

Dadurch, dass eine dritte Elektrode mit dem ersten und zweiten Halbleiterbauteil jeweils über einen dritten Kontaktpunkt elektrisch leitend verbunden ist, wird ein Leuchtmittel ausgebildet, das eine gezielte und insbesondere getrennte elektrische Ansteuerung der beiden Halbleiterbauteile gestattet. Aus thermischer Sicht hat diese Ausbildung jedoch noch den weiteren besonderen Vorteil, dass sich die Wärmedehnungen der Halbleiterbauteile, aufgrund des bestimmungsgemäßen Betriebs, nicht auf die Zuverlässigkeit der elektrischen Kontaktierung auswirken. Bei Betrieb der Halbleiterbauteil erwärmen sich diese teilweise sehr stark, wobei diese Verlustwärme zumeist über die großvolumig ausgebildete Trägerlage abgeführt wird. Zur elektrischen Kontaktierung sind die Halbleiterbauteile ggf. mit der Trägerlage elektrisch leitend verbunden, wobei diese Kontaktierung die elektrische Versorgung sicher stellen muss und zusätzlich die auftretenden mechanischen Spannungen aufgrund der Wärmedehnung aufnehmen können muss, was im Dauerbetrieb ggf. zu einer Beschädigung der Verbindung führen kann. Daher können die Verbindung der Halbleiterbauteile mit der Trägerlage auf eine gute Wärmeleitung optimiert werden, ohne dadurch die elektrische Versorgung zu beeinträchtigen bzw. auf diese Rücksicht nehmen zu müssen.

Selbstverständlich können auch die dritten Kontaktpunkte von einem Mittelpunkt bzw. einer Symmetrielinie der Trägerlage jeweils einen unterschiedlichen Abstand aufweisen, wodurch man die bereits beschriebenen Vorteile bezüglich der Verbesserung der Verteilung der Strahlungsintensität erhält.

Eine ganz besonders vorteilhafte Weiterbildung erhält man, wenn die Trägerlage als optischer Reflektor ausgebildet ist. Die Halbleiterbauteile weisen bauartbedingt zumeist eine Hauptabstrahlungsrichtung aus, die ggf. nicht der gewünschten Strahlungsrichtung und Abstrahlungscharakteristik des Leuchtmittels entspricht. Durch die Ausbildung der Trägerlage als optischer Reflektor lässt sich ein Teil des abgestrahlten Lichts in Richtung der gewünschten Hauptstrahlrichtung umlenken, was den optischen Wirkungsgrad deutlich verbessert.

Ebenfalls von Vorteil ist eine Ausbildung, bei der auf der Trägerlage ein fotoaktives Material angeordnet ist. Das fotoaktive Material ist bevorzugt lumineszent, das heißt, es kommt durch Anregung mit einer elektromagnetischen Strahlung zur Abgabe von elektromagnetischer Strahlung, bevorzugt in einem anderen Spektralbereich. Aufgrund technologisch bedingter Materialeigenschaften kann mit Halbleiterbauteilen nicht im gesamten optischen Spektralbereich Strahlung erzeugt werden. Mit dieser Weiterbildung ist es nun in vorteilhafter Weise möglich, eine abgegebene elektromagnetische Strahlung durch das fotoaktive Material in einen anderen Spektralbereich zu transferieren, bzw. den abgegebenen Spektralbereich zu erweitern. Beispielsweise lässt sich weißes Licht mit Halbleiterbauteilen direkt nicht erzeugen, sondern es wird bevorzugt ein im blauen Spektralbereich abstrahlender Halbleiter auf der Trägerlage angeordnet. Das anspruchsgemäß auf der Trägerlage angeordnete fotoaktive Material wird bei Anregung mit blauem Licht angeregt und gibt, aufgrund von Spontanemission, elektromagnetische Strahlung in einem weiten Spektralbereich ab, sodass vom Leuchtmittel insgesamt weißes Licht abgegeben wird. Ebenso sind auch Ausbildungen denkbar, bei denen vom Halbleiterbauteil Licht im nicht sichtbaren optischen Spektralbereich abgegeben wird und durch das fotoaktive Material in den sichtbaren Bereich transferiert wird.

Neben einem Mittelpunkt bzw. einer Symmetrielinie der Trägerlage weist das erfindungsgemäße Leuchtmittel zumeist auch noch eine optische Achse auf, die bevorzugt der Hauptstrahlungsrichtung des erfindungsgemäßen Leuchtmittels entspricht. In einer vorteilhaften Weiterbildung weist nun der erste und zweite Kontaktpunkt bzgl. einer optischen Achse des Leuchtmittels einen unterschiedlichen Abstand auf, wodurch sichergestellt ist, dass sich die vom ersten und zweiten Halbleiterbauteil abgegebene elektromagnetische Strahlung derart vorteilhaft überlagert, dass die bauartbedingten Helligkeitsunterschiede im Lichtstrahl weitestgehend ausgeglichen werden. Die Ausbildung stellt weiters sicher, dass unabhängig von der konkreten Detailausbildung der Halbleiterbauteile bzw. der Trägerlage, die Halbleiterbauteile derart angeordnet bzw. kontaktiert werden, dass sich die abgegebenen Lichtstrahlen konstruktiv überlagern und somit eine gleichmäßige Intensität des abgegebenen Lichtstrahls einstellt.

Die anspruchsgemäße Weiterbildung lässt sich selbstverständlich auch auf eine Weiterbildung anwenden, bei der die Halbleiterbauteile über dritte Kontaktpunkte elektrisch leitend kontaktiert sind, wobei sich wiederum die bereits beschriebenen Vorteile ergeben.

Eine vorteilhafte Weiterbildung erhält man, wenn die Trägerlage und die Elektrodenanordnung in einem Gehäuse angeordnet sind, wobei das Gehäuse aus einem Licht leitenden Material gebildet ist. Eine Anordnung in einem Gehäuse hat den Vorteil, dass ein ausreichender mechanischer Schutz der Halbleiterbauteile sichergestellt ist und sich die Montage bzw. Anordnung des Leuchtmittels in einem weiteren Modul deutlich vereinfacht. Wenn das Gehäuse aus einem Licht leitenden Material gebildet ist erhält man den besonderen Vorteil, dass durch dieses Material bereits eine Lichtlenkung bzw. Lichtsammlung möglich ist und somit der optische Wirkungsgrad des erfindungsgemäßen Leuchtmittels wiederum verbessert werden kann. Das Licht leitende Material kann bspw. noch zur spektralen Filterung ausgebildet sein, um so unerwünschte Spektralkomponenten auszufiltern und einen möglichst schmalen Spektralbereich abzugeben. Das Licht leitende Material kann jedoch auch zur diffusen Streuung ausgebildet sein, um so, im Bezug zu einer optischen Achse des Leuchtmittels, eine Leuchtwirkung in einen möglichst breiten Raumbereich zu erreichen.

Hinsichtlich der Strahlformung bzw. Richtwirkung der abgegebenen elektromagnetischen Strahlung kann gemäß einer Weiterbildung das Gehäuse ein Licht lenkendes Element aufweisen. Ein derartiges Element ist bspw. eine optische Linse die im Strahlengang der elektromagnetischen Strahlung angeordnet ist und durch ihre Ausbildung hinsichtlich der Fokuspunkte eine Festlegung des Öffnungswinkels der abgegebenen elektromagnetischen Strahlung einstellen lässt. Bevorzugt ist ein Öffnungswinkel von 22°, da dadurch eine weitestgehend gerichtete Strahlung abgegeben wird.

In einer Weiterbildung ist eine Strahlrichtung auch alleine dadurch möglich, dass die Halbleiterbauteile derart angeordnet sind, dass es aufgrund einer konstruktiven und destruktiven Überlagerung zu einer Ausbildung einer Richtcharakteristik des abgegebenen Lichtstrahls kommt. Insbesondere ist somit auch eine Festlegung des Öffnungswinkels möglich, bspw. wiederum auf die bevorzugten 22°.

Bei bekannten Leuchtmitteln wird zumeist ein hoch integriertes Halbleiterbauteil auf einer Trägerlage angeordnet, wobei das Halbleiterbauteil ggf. mehrere Licht abgebende Elemente aufweisen kann, die in bekannter Weise elektrisch kontaktiert werden, wodurch es zu Intensitätsschwankungen im Querschnitt des abgegebenen Lichtstrahl kommt. Durch die anspruchsgemäße Ausbildung, bei der das erste und zweite Halbleiterbauteil voneinander distanziert auf der Trägerlage angeordnet sind, lässt sich in vorteilhafter Weise sicherstellen, dass bereits durch die distanzierte Anordnung, das Auftreten von Intensitätsschwankungen im abgegebenen Lichtstrahl deutlich reduziert werden kann.

Zum besseren Verständnis der Erfindung wird diese anhand der nachfolgenden Figuren näher erläutert.

Es zeigen jeweils in stark schematisch vereinfachter Darstellung:
- Fig. 1: eine Ausbildung des erfindungsgemäßen Leuchtmittels in Draufsicht;
- Fig. 2: das Leuchtmittel aus Fig. 1 in perspektivischer Darstellung;
- Fig. 3: eine weitere Ausbildung des erfindungsgemäßen Leuchtmittels;
- Fig. 4: eine weitere Ausbildung des erfindungsgemäßen Leuchtmittels in perspektivischer Darstellung.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mitumfasst sind, d.h. sämtliche Teilbereich beginnen mit einer unteren Grenze von 1 oder größer und enden bei einer oberen Grenze von 10 oder weniger, z.B. 1 bis 1,7, oder 3,2 bis 8,1 oder 5,5 bis 10.

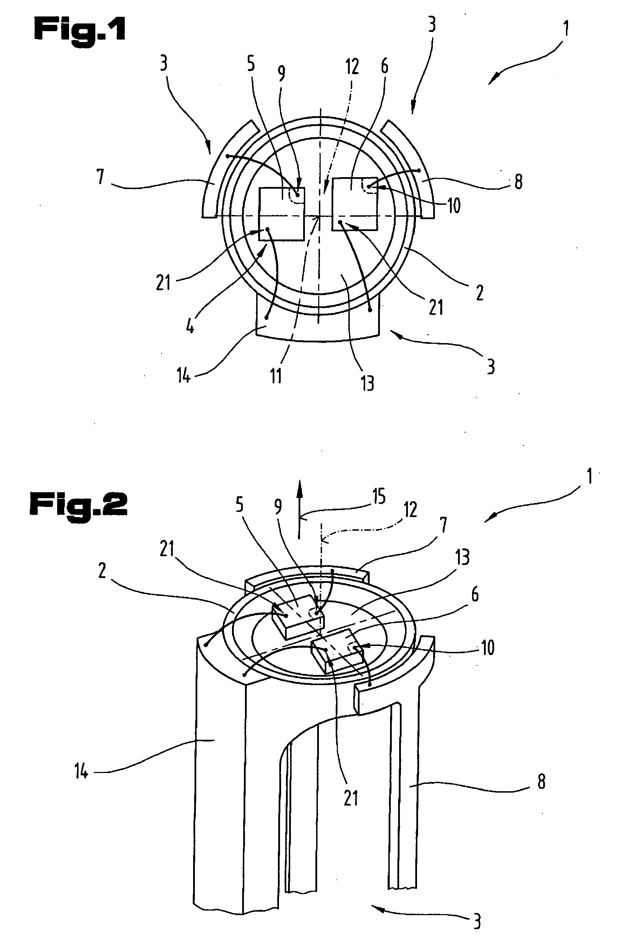

Fig. 1 zeigt eine Ausbildung des erfindungsgemäßen Leuchtmittels 1, umfassend eine Trägerlage 2, eine Elektrodenanordnung 3 sowie eine Quelle für elektromagnetische Strahlung 4. Die Quelle für elektromagnetische Strahlung 4 ist durch ein erstes 5 und zweites 6 Halbleiterbauteil gebildet, wobei die Halbleiterbauteile bevorzugt als Leuchtdiode ausgebildet sind. Die Elektrodenanordnung 3 umfasst eine Mehrzahl von Elektroden, insbesondere eine erste 7, zweite 8 und dritte 14 Elektrode. Das erste Halbleiterbauteil 5 ist mit der ersten Elektroden 7 elektrisch leitend verbunden, wobei die Verbindungsleitung das erste Halbleiterbauteil 5 in einem ersten Kontaktpunkt 9 elektrisch leitend kontaktiert. Gleiches gilt für das zweite Halbleiterbauteil 6 und die zweite Elektrode 8, wobei die Kontaktierung hier über einen zweiten Kontaktpunkt 10 erfolgt. Der Betrieb einer Leuchtdiode als Halbleiterbauteil erfordert eine zweipolige elektrische Versorgung. In der dargestellten Ausbildung werden die Halbleiterbauteile 5, 6 über dritte Kontaktpunkte 21 mit der dritten Elektrode 14 elektrisch leitend verbunden.

Die Trägerlage 2 ist im dargestellten Fall im Wesentlichen kreisrund ausgebildet, sodass sich eindeutig ein Mittelpunkt 11 der geometrischen Figur der Trägerlage angeben lässt. Die Trägerlage kann jedoch auch eine andere geometrische Form ausbilden, bspw. sind rechteckige oder quadratische Ausbildungen möglich, wobei sich für derartige Ausbildungen eine Symmetrielinie 12 angeben lässt. Wesentlich an dem erfindungsgemäßen Leuchtmittel ist nun, das der erste 9 und zweite 10 Kontaktpunkt vom Mittelpunkt 11 bzw. einer Symmetrielinie 12 einen unterschiedlichen Abstand haben. Insbesondere bedeutet dies, dass der erste 9 und zweite 10 Kontaktpunkt am ersten 5 und zweiten 6 Halbleiterbauteil derart angeordnet sind, dass die Anordnung bzgl. des Mittelpunkts 11 bzw. einer Symmetrielinie 12 keine Symmetrie ausbilden. Gleiches gilt für die Anordnung der dritten Kontaktpunkte 21 auf den Halbleiterbauteilen 5, 6.

Das erste 5 und zweite 6 Halbleiterbauteil ist bevorzugt derart ausgebildet, dass die elektromagnetische Strahlung weitestgehend im selben Spektralbereich abgegeben wird, wobei dies bspw. der optisch sichtbare Bereich sein kann. Es ist jedoch auch eine Ausbildung möglich, bei der die Halbleiterbauteile Licht im nicht sichtbaren optischen Bereich abgeben, welches durch ein optisch aktives Material in den optisch sichtbaren Bereich transferiert wird. Ein derart optisch aktives Material 13, oder Transfermaterial, ist bevorzugt auf der Trägerlage 2 derart angeordnet, dass die vom ersten 5 und zweiten 6 Halbleiterbauteil abgegebene elektromagnetische Strahlung, unmittelbar in das optisch aktive Material 13 einwirken kann, wodurch es in diesem bevorzugt aufgrund von Spontanemission, zur Abgabe von Licht in einem anderen Wellenlängenbereich kommt, insbesondere im sichtbaren optischen Bereich.

Fig. 2 zeigt das Leuchtmittel 1 aus Fig. 1 in perspektivischer Darstellung. Die Trägerlage 2 ist bevorzugt als optischer Reflektor ausgebildet, um das von den Halbleiterbauteilen abgegebene Licht, bzw. das ggf. durch das optisch aktive Material 13 transferierte Licht, bevorzugt in eine Hauptabstrahlrichtung 15 zu lenken. Zumeist stimmt die Hauptabstrahlrichtung 15 auch mit einer Symmetrielinie 12 überein, sodass es aufgrund der erfindungsgemäßen Anordnung des ersten 9 und zweiten 10 Kontaktpunkts bzw. der dritten Kontaktpunkte 21, zu keinen bzw. nur sehr geringen Intensitätsunterschieden in der Querschnittsfläche des abgegebenen Lichtstrahls kommt. Die unvermeidliche Abschattung aufgrund der Kontaktpunkte 9, 10, 21 ist im weitestgehenden kreisförmigen Querschnitt des abgegebenen Lichtstrahls durch einen Kreisring mit geringerer Intensität erkennbar. Durch die erfindungsgemäße Anordnung überlagern sich die Lichtstrahlen der beiden Halbleiterbauteile 5, 6 und es kommt somit zu einer weitestgehenden Ausgleichung der Strahlungsintensität und somit zu einem gleichmäßigen Leuchtbild.

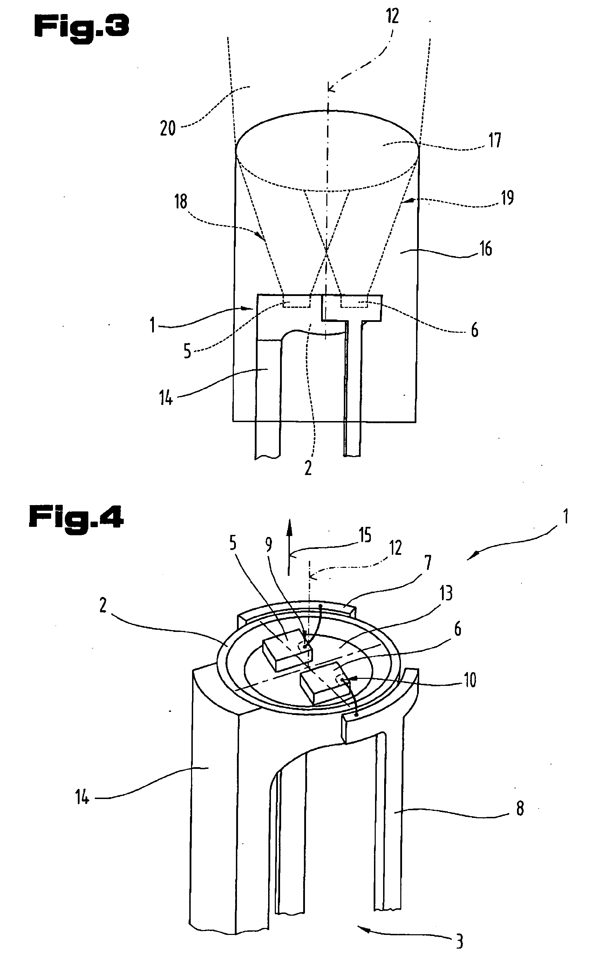

Durch die Ausbildung der Trägerlage 2 als Reflektor ist eine erste Möglichkeit zur Strahllenkung bzw. Strahlformung gegebenen. Gegebenenfalls kann im Strahlengang 15 noch eine Strahlformeinrichtung angeordnet sein, bevorzugt wird diese als optisch wirkende Linse ausgebildet sein, wie dies bspw. in Fig. 3 dargestellt ist.

Fig. 3 zeigte eine weitere mögliche Ausbildung, bei der das erfindungsgemäße Leuchtmittel 1 in einem Gehäuse 16 angeordnet ist, wobei im Gehäuse eine Strahlrichteinrichtung 17 angeordnet ist, die bevorzugt als optische Linse ausgebildet ist. Vom ersten Halbleiterbauteil 5 wird ein erster Lichtstrahl 18 abgegeben, vom zweiten Halbleiterbauteil 6 wird ein zweiter Lichtstrahl 19 abgegeben, wobei die Lichtstrahlen aufgrund der Ausbildung der Trägerlage 2 als Reflektor bereits weitestgehend gerichtet in Richtung 15 der Strahlrichteinrichtung 17 gelenkt werden. Aufgrund der elektrischen Kontaktierungspunkte auf den Halbleiterbauteilen gibt es im ersten 18 und zweiten 19 Strahlengang Abschnitte mit verringerter Lichtintensität. Durch die Überlagerung der beiden Lichtstrahlen und insbesondere durch die Zusammenführung der beiden Lichtstrahlen durch die Strahlrichteinrichtung 17 weist der gegebene Strahlengang 20 eine gleichmäßige Intensitätsverteilung auf, insbesondere werden die bauartbedingten Intensitätsunterschiede weitestgehend ausgeglichen. Durch diese vorteilhafte Ausbildung ist sichergestellt, dass ein Lichtstrahl 20 mit über dem Querschnitt weitestgehend konstanter Intensität abgegeben wird.

Die Strahlrichteinrichtung 17 hat in Kombination mit der Ausbildung der Trägerlage 2 den weiteren Vorteil, dass der Öffnungswinkel des Strahlengangs 20 in weiten Bereichen festlegbar ist, bevorzugt wird ein Abstrahlwinkel von 22°, was einer weitestgehend gerichteten Abstrahlung entspricht.

Eine weitere vorteilhafte Ausbildung erhält man bei gezielter Ansteuerung des ersten 5 und zweiten 6 Halbleiterbauteils. Zur Erreichung einer möglichst hohen Intensität des Strahlengangs 20 wird bei bekannten Vorrichtungen mit einem Halbleiterbauteil, dieses zumeist mit der maximal möglichen Leistung betrieben, um so eine möglichst hohe Intensität des abgegebenen Lichts zu erreichen. Beim erfindungsgemäß ausgebildeten Leuchtmittel ist es in vorteilhafter Weise möglich, beide Leuchtmittel 5, 6 mit verringerter Leistung anzusteuern und trotzdem eine hohe Strahlungsintensität des Strahlengangs 20 zu erreichen. Dies hat den Vorteil, dass jeder Halbleiterbauteil deutlich geringer belastet wird, was sich insbesondere in einer geringeren Wärmeentwicklung auswirkt und trotzdem eine hohe Gesamtstrahlungsintensität erreicht wird.

Aufgrund der erfindungsgemäßen Ausbildung der Elektrodenanordnung ist es weiters möglich, ein Halbleiterbauteil mit Nennleistung zu betreiben, währen das zweite Halbleiterbauteil als Ausfallsicherung erst dann zum Einsatz kommt, wenn das erste Halbleiterbauteil schadhaft geworden ist bzw. wenn aufgrund von Alterungserscheinungen die abgegebene Lichtintensität unter einem Grenzwert absinkt. Durch diese Ausbildung bringt das erfindungsgemäße Leuchtmittel den Vorteil, dass trotz kompakter Abmessungen eine hohe Betriebssicherheit erzielt wird und gleichzeitig eine möglichst gleichmäßige Strahlungsintensität im abgegebenen Lichtstrahl gegeben ist. Weitere Möglichkeiten der Ansteuerung der beiden Halbleiterbauteile können bspw. darin bestehen, dass die einzelnen Bauteile gepulst angesteuert werden, was wiederum die Belastung für das einzelne Bauteil reduziert und trotzdem eine hohe und gleichmäßige Strahlungsintensität sicherstellt.

Fig. 4 zeigt eine weitere Ausbildung des erfindungsgemäßen Leuchtmittels, bei dem die Trägerlage 2 elektrisch leitend ausgebildet ist und somit die dritte Elektrode 14 der Elektrodenanordnung 3 ausbildet. Diese Ausbildung hat den Vorteil, dass die elektrische Kontaktierung der Halbleiterbauteile über die Trägerlage erfolgt und somit keine zusätzlichen Verbindungsleitungen angeordnet werden müssen, was deutliche Herstellungskosten einspart. Insbesondere entfallen somit die dritten Kontaktpunkte der Halbleiterbauteile 5, 6.

Die Ausführungsbeispiele zeigen mögliche Ausführungsvarianten des Leuchtmittels, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mit umfasst.

In der Fig. 4 ist eine weitere und gegebenenfalls für sich eigenständige Ausführungsform des Leuchtmittels gezeigt, wobei wiederum für gleiche Teile gleiche Bezugszeichen bzw. Bauteilbezeichnungen wie in den vorangegangenen Fig. 1 bis 3 verwendet werden. Um unnötige Wiederholungen zu vermeiden, wird auf die detaillierte Beschreibung in den vorangegangenen Figuren hingewiesen bzw. Bezug genommen.

Der Ordnung halber sei abschließend darauf hingewiesen, dass zum besseren Verständnis des Aufbaus des Leuchtmittels diese bzw. deren Bestandteile teilweise unmaßstäblich und/oder vergrößert und/oder verkleinert dargestellt wurden.

Die den eigenständigen erfinderischen Lösungen zugrunde liegende Aufgabe kann der Beschreibung entnommen werden.

Vor allem können die einzelnen in den Fig. 1 bis 4 gezeigten Ausführungen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

### Bezugszeichenaufstellung

- 1: Leuchtmittel
- 2: Trägerlage
- 3: Elektrodenanordnung
- 4: Quelle für elektromagnetische Strahlung
- 5: Erstes Halbleiterbauteil

- 6: Zweites Halbleiterbauteil
- 7: Erste Elektrode
- 8: Zweite Elektrode
- 9: Erster Kontaktpunkt
- 10: Zweiter Kontaktpunkt

- 11: Mittelpunkt
- 12: Symmetrielinie
- 13: Fotoaktives Material
- 14: Dritte Elektrode
- 15: Optische Achse, Richtung, Strahlengang

- 16: Gehäuse
- 17: Strahlrichteinrichtung, Linse
- 18: Erster Lichtstrahl
- 19: Zweiter Lichtstrahl
- 20: Strahlengang

- 21: Dritter Kontaktpunkt

## Patentansprüche

1. Leuchtmittel (1) umfassend eine Strahlungsquelle (4) zur Abgabe von elektromagnetischer Strahlung im optischen Bereich, eine Trägerlage (2) und eine Elektrodenanordnung (3) mit einer ersten (7) und zumindest zweiten (8) Elektrode, wobei die Strahlungsquelle (4) auf der Trägerlage (2) angeordnet ist und mittels Verbindungsleitungen mit der Elektrodenanordnung (3) elektrisch leitend verbunden ist, wobei die Strahlungsquelle (4) durch ein erstes (5) und zumindest zweites (6) Halbleiterbauteil gebildet ist, wobei die erste Elektrode (7) mit dem ersten Halbleiterbauteil (5) über einen ersten Kontaktpunkt (9) elektrisch leitend verbunden ist und die zweite Elektrode (8) mit dem zweiten Halbleiterbauteil (6) über einen zweiten Kontaktpunkt (10) elektrisch leitend verbunden ist, **dadurch gekennzeichnet, dass** der Abstand des ersten Kontaktpunkts (9) von einem Mittelpunkt (11) bzw. einer Symmetrielinie (12) der Trägerlage (2) unterschiedlich ist vom Abstand des zweiten Kontaktpunkts (10) zum Mittelpunkt (11) bzw. zur Symmetrielinie (12) der Trägerlage.

2. Leuchtmittel nach Anspruch 1, **dadurch gekennzeichnet, dass** das erste (5) und zweite (6) Halbleiterbauteil durch eine Leuchtdiode gebildet ist.

3. Leuchtmittel nach einem der Ansprüche 1 oder 2, **dadurch gekennzeichnet, dass** das erste (5) und/oder zweite (6) Halbleiterbauteil eine elektromagnetische Strahlung im sichtbaren optischen Bereich abgibt.

4. Leuchtmittel nach einem der Ansprüche 1 bis 3, **dadurch gekennzeichnet, dass** das erste (5) und/oder zweite (6) Halbleiterbauteil eine elektromagnetische Strahlung im nicht sichtbaren optischen Bereich abgibt.

5. Leuchtmittel nach einem der Ansprüche 1 bis 4, **dadurch gekennzeichnet, dass** die Trägerlage (2) elektrisch leitend ausgebildet ist.

6. Leuchtmittel nach einem der Ansprüche 1 bis 5, **dadurch gekennzeichnet, dass** die Trägerlage (2) elektrisch nicht leitend ausgebildet ist.

7. Leuchtmittel nach einem der Ansprüche 1 bis 6, **dadurch gekennzeichnet, dass** eine dritte Elektrode (14) mit dem ersten (5) und zweiten (6) Halbleiterbauteil jeweils über einen dritten Kontaktpunkt (21) elektrisch leitend verbunden ist.

8. Leuchtmittel nach einem der Ansprüche 1 bis 7, **dadurch gekennzeichnet, dass** die Trägerlage (2) als optischer Reflektor ausgebildet ist.

9. Leuchtmittel nach einem der Ansprüche 1 bis 8, **dadurch gekennzeichnet, dass** auf der Trägerlage (2) ein fotoaktives Material (13) angeordnet ist.

10. Leuchtmittel nach einem der Ansprüche 1 bis 9, **dadurch gekennzeichnet, dass** der erste (9) und zweite (10) Kontaktpunkt bzgl. einer optischen Achse (15) des Leuchtmittels einen unterschiedlichen Abstand aufweist.

11. Leuchtmittel nach einem der Ansprüche 1 bis 10, **dadurch gekennzeichnet, dass** die Trägerlage (2) und die Elektrodenanordnung (3) in einem Gehäuse (16) angeordnet sind, wobei das Gehäuse aus einem Licht leitenden Material gebildet ist.

12. Leuchtmittel nach Anspruch 11, **dadurch gekennzeichnet, dass** das Gehäuse (16) ein Licht lenkendes Element (17) aufweist.

13. Leuchtmittel nach einem der Ansprüche 1 bis 12, **dadurch gekennzeichnet, dass** das erste (5) und zweite (6) Halbleiterbauteil voneinander distanziert auf der Trägerlage (2) angeordnet sind.
